**Europäisches Patentamt**

**European Patent Office**

**Office européen des brevets**

(19)

(11) Veröffentlichungsnummer : **0 601 214 B1**

(12)

# EUROPÄISCHE PATENTSCHRIFT

(45) Veröffentlichungstag der Patentschrift :
**25.10.95 Patentblatt 95/43**

(51) Int. Cl.⁶ : **G01D 5/245,** H03M 1/00,
**G01D 5/36**

(21) Anmeldenummer : **92119101.1**

(22) Anmeldetag : **07.11.92**

(54) **Signalüberwachungsverfahren.**

(43) Veröffentlichungstag der Anmeldung :
**15.06.94 Patentblatt 94/24**

(45) Bekanntmachung des Hinweises auf die
Patenterteilung :
**25.10.95 Patentblatt 95/43**

(84) Benannte Vertragsstaaten :
**DE FR GB IT**

(56) Entgegenhaltungen :
**EP-A- 0 408 799**

(56) Entgegenhaltungen :
**DE-A- 2 022 151**
**PATENT ABSTRACTS OF JAPAN, Bd. 14, Nr.
358 (P-1087) 2. August 1990; & JP-A-21 30 421
PATENT ABSTRACTS OF JAPAN, Bd. 10, Nr.
80 (P-441) 29. März 1986; & JP-A-60 218 026**

(73) Patentinhaber : **Dr. Johannes Heidenhain
GmbH
Postfach 12 60
D-83292 Traunreut (DE)**

(72) Erfinder : **Kranitzky, Walter, Dr. Dipl.-Phys.
Innstrasse 15
W-8220 Traunstein (DE)**

EP 0 601 214 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf ein Verfahren nach dem Oberbegriff des Anspruches 1.

Verfahren zur Signalüberwachung sind bekannt, beispielsweise aus der DE-20 22 151 C3.

Ferner ist aus der EP 0 408 799 A1 bekannt, daß zumindest bei der Darstellung am Oszillografen ein Kreis entsteht, wenn im Polarkoordinatensystem die momentanen Werte von Sinus und Cosinus der Meßsystemsignale eingetragen werden.

Längen- und Winkelmeßsysteme, die auf dem Prinzip der photoelektrischen Abtastung einer Inkrementaltalspur basieren, liefern diese zwei um neunzig Grad phasenverschobenen sinusförmigen Meßsignale. Um Fehlmessungen auf Grund des Ausfalls der Lichtquelle, wegen defekter Photoelemente oder wegen Verschmutzung des Maßstabes auszuschließen, wird die Signalqualität in herkömmlichen Meß- bzw. Auswertesystemen überwacht. Dabei erfolgt eine Kontrolle des Betrages des Signalvektors. Ist der Betrag kleiner als ein vorbestimmter Schwellwert, so wird ein Fehlersignal ausgegeben. Die Signalüberwachung kann auch mit mehreren Schwellwerten, sowie in analoger oder digitaler Schaltungstechnik ausgeführt werden.

Es ist bekannt, daß es Fehlfunktionen des Meßsystemes gibt, die mit der oben beschriebenen Art der Überwachung nicht erkannt werden können. Fällt z.B. eine der beiden Photodioden eines Meßkanals aus, so ist es möglich, daß der Signalvektor eine Ellipse beschreibt, die den überwachten Amplitudenbereich nicht schneidet. Die Lage der Ellipse und damit die Möglichkeit, den Fehler zu erkennen, hängt u.a. vom Gleichlichtanteil (Abgleich) des Meßsignales ab und ist somit von System zu System unterschiedlich.

Der Erfindung liegt die Aufgabe zugrunde, ein Verfahren zur Signalüberwachung anzugeben, das vielseitiger einsetzbar ist und mit dem sich auch die vorgenannten Fehlerquellen ermitteln lassen.

Diese Aufgabe wird von einem Verfahren gemäß dem Anspruch 1 gelöst.

Die Vorteile des Verfahrens liegen in der größeren Bandbreite der Fehlererkennung. Es lassen sich nicht nur große Abweichungen vom Normalzustand bei Ausfall eines Photoelementes erkennen. Vielmehr werden auch geringe Unsymmetrien der Meßsignale detektiert. Daher stellt dieses Verfahren auch eine Abgleichhilfe dar.

Mit Hilfe der Zeichnungen wird das Verfahren erläutert.

Es zeigt

Figur 1          ein schematisch dargestelltes inkrementales Meßsystem;
Figur 2          ein typisches Signaldiagramm;
Figur 3          einen Auswertebaustein;
Figur 4          ein Rechtecksignaldiagramm und die
Figuren 5 bis 7  verschiedene Zeigerdiagramme

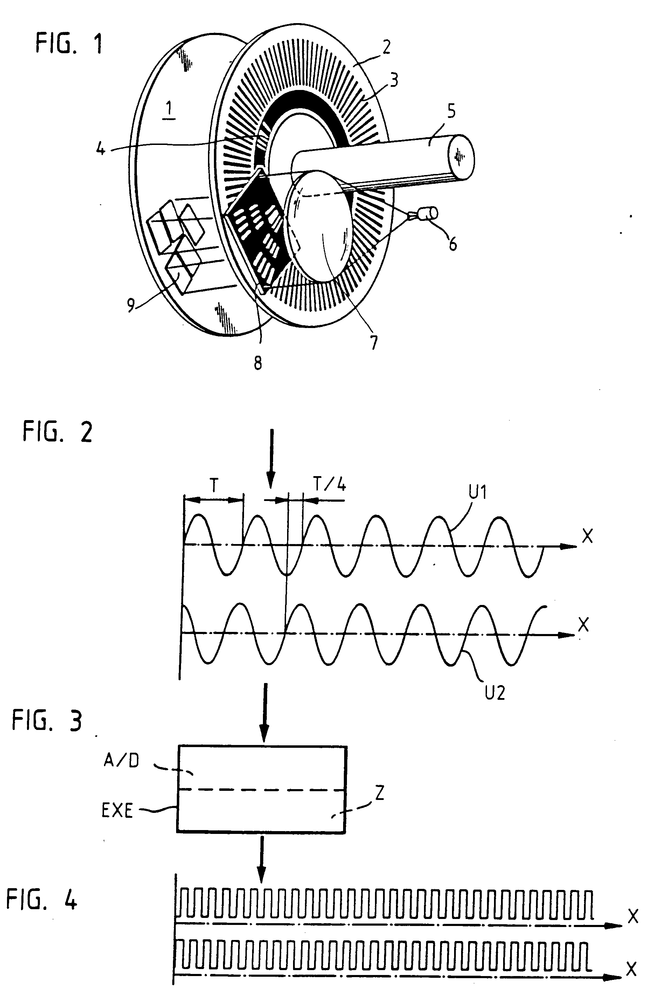

Ein in Figur 1 skizziertes Meßsystem 1 wird durch einen inkrementalen Drehgeber gebildet. Als Maßverkörperung dient hier eine Teilscheibe 2 mit einem Radialgitter 3. Auf einer weiteren konzentrischen Spur befindet sich eine Referenzmarke 4, die hier aber nicht weiter abgehandelt werden soll. Die Teilscheibe 2 ist mit einer Welle 5 verbunden, deren Position gemessen werden soll. Dazu wird das Radialgitter 3 von einer nicht näher bezeichneten Abtasteinheit abgetastet. Die wesentlichen Bestandteile der Abtasteinheit sind eine Lichtquelle 6, ein Kondensor 7, eine Abtastplatte 8 und Fotodetektoren 9.

Bei einer Bewegung der Teilscheibe 2 relativ zur Abtasteinheit kommen die Striche und Lücken des Radialgitters 3 abwechselnd mit denen der Abtastgitter der Abtastplatte 8 zur Deckung. Die Fotodetektoren 9 setzen den sich periodisch ändernden Lichtstrom in elektrische Signale um. Als Ausgangssignale stehen gemäß Figur 2 zwei sinusförmige Signale U1 und U2 zur Verfügung. Sie sind um 90° elektrisch zueinander phasenverschoben, was durch zwei Fotodetektoren 9 bewirkt wird, die um 1/4 der Teilungsperiode T zueinander versetzt sind.

In einer in Figur 3 dargestellten Auswerteeinrichtung EXE erfolgt die Digitalisierung und die Interpolation. Die Interpolationswerte werden vorab ermittelt und sind in einem Festwertspeicher Z abgespeichert. Am Ausgang der Auswerteeinrichtung EXE stehen die digitalisierten und interpolierten Signale in Form von zählbaren Rechteckimpulsen an, was in Figur 4 gezeigt ist.

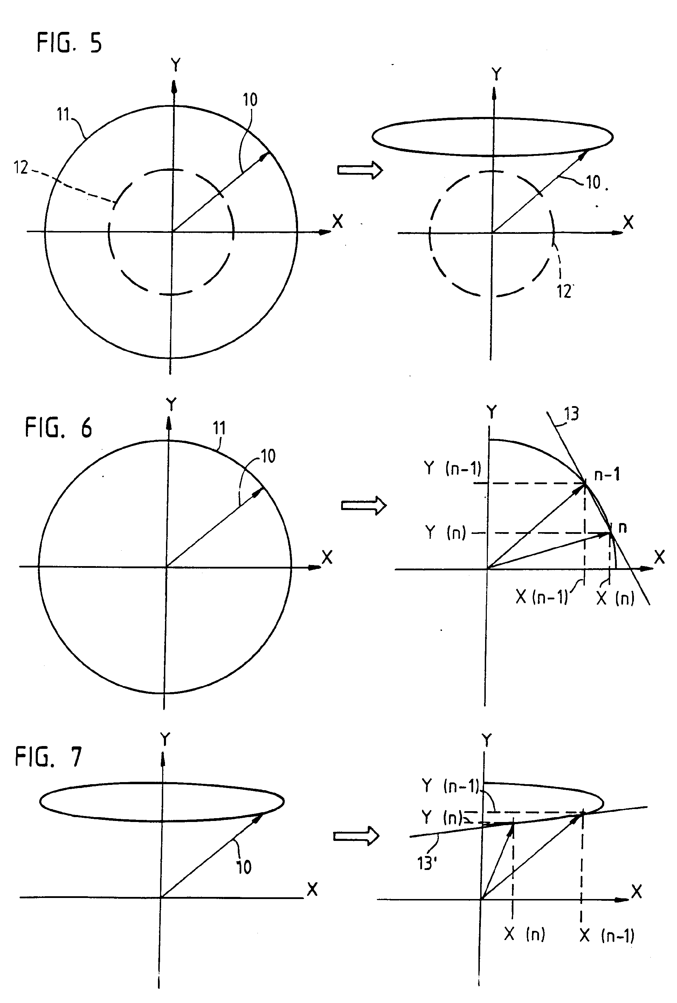

In Figur 5 ist ein Zeigerdiagramm dargestellt, das einen vom resultierenden Signalvektor 10 beschriebenen Kreis 11 zeigt.

Bekanntlich entsteht ein Kreis 11, wenn man die momentanen Werte von Sinus und Cosinus in einem Koordinatensystem einträgt. Der Durchmesser des Kreises ist dabei vom Betrag der Amplituden abhängig. Die Fläche innerhalb eines Kreises 12 mit dem kleineren Durchmesser gibt den Bereich an, in dem die Amplituden zu klein sind, um die Abtastsignale auswerten zu können. Der Bereich außerhalb des Kreises 11 mit dem größeren Durchmesser gibt den Übersteuerungsbereich an, das heißt, die Signalamplituden sind zu groß. Der zulässige Bereich liegt also auf der Kreisringsfläche zwischen den beiden Kreisen 11 und 12.

Um Fehlmessungen auf Grund des Ausfalls der Lichtquelle 6, wegen defekter Photoelemente 9 oder wegen Verschmutzung des Maßstabes auszuschließen, wird die Signalqualität auf diese Weise überwacht. Dabei erfolgt eine Kontrolle des Betrages des Signalvektors. Ist der Betrag kleiner als ein vorbestimmter Schwellwert, so wird ein Fehlersignal ausgegeben. Die Signalüberwachung kann auch mit mehreren Schwellwerten ausgeführt werden.

Es ist bekannt, daß es Fehlfunktionen des Meßsystemes 1 gibt, die mit der oben beschriebenen Art der Überwachung nicht erkannt werden können. Fällt z.B. eine der beiden Photodioden 9 eines Meßkanals aus, so ist es möglich, daß der Signalvektor 10 eine Ellipse beschreibt, die den überwachten Amplitudenbereich - dargestellt durch den Kreis 12 - nicht schneidet. Die Lage der Ellipse und damit die Möglichkeit, den Fehler zu erkennen, hängt u.a. vom Gleichlichtanteil (Abgleich) der Meßsignale U1, U2 ab, ist somit von System zu System unterschiedlich, und wird im rechten Teil von Figur 5 gezeigt.

Figur 6 zeigt ein Zeigerdiagramm mit dessen Hilfe die Erfindung beschrieben werden soll. Die Zeigerdarstellung ermöglicht die Beschreibung des erfindungsgemäßen Verfahrens. Im linken Bildbereich ist wieder der vom resultierenden Signalvektor 10 erzeugte Kreis 11 vorhanden. Durch Spiegelung an der x- und y-Achse wird der vom Signalvektor 10 beschriebene Kreis 11 auf den ersten Quadranten dieses Koordinatensystemes abgebildet. Zur Auswertung werden jeweils zwei aufeinanderfolgende Meßwertpaare x(n-1), y(n-1); x(n), y(n) herangezogen, das heißt es wird die zeitliche Änderung des Vektors 10 betrachtet, was im rechten Bildbereich von Figur 6 dargestellt ist.

Durch jeweils zwei aufeinanderfolgende Meßwertpunkte n-1;n, die durch die Meßwertpaare x(n-1), y(n-1) und x(n), y(n) bestimmt sind, wird eine Gerade 13 gelegt. Durch Differenzbildung wird das Vorzeichen der Steigung der die beiden Meßwertpunkte n-1;n verbindenden Geraden 13 ermittelt:

$$S = sign(x(n) - x(n - 1)) * sign(y(n) - y(n - 1))$$

Die Funktion sign ist wie folgt definiert:

sign(a) = +1 für a>0

sign(a) = 0 für a=0

sign(a) = -1 für a<0

Im normalen Betriebszustand ergibt sich immer eine negative Steigung S=-1.

Ebenso fehlerfrei ist das Ergebnis S=0, da es Stillstand signalisiert.

In Figur 7 ist analog eine Situation im Fehlerzustand dargestellt. Wie ersichtlich ist, ist in diesem Fall die Steigung S=+1, also hat die Gerade 13' zwischen den zwei Meßwertpunkten n-1;n im Fehlerfall immer eine positive Steigung.

Auf diese Weise lassen sich nicht nur grobe Abweichungen vom Normalzustand bei Ausfall eines Photoelementes 9 erkennen. Vielmehr werden auch geringe Unsymmetrien der Meßsignale U1, U2 detektiert, wodurch dieses Verfahren auch als Abgleichhilfe dienen kann.

Anhand der Figuren 6 und 7 soll die Ermittlung des Vorzeichens mit Hilfe des Terms

$$S = sign(x(n) - x(n - 1)) * sign(y(n) - y(n - 1))$$

und einfachen Zahlenbeispielen deutlich gemacht werden.

Im Fall der Figur 6 sei angenommen, x(n) habe den Wert 4 und x(n-1) den Wert 3; y(n) habe den Wert 2 und y(n-1) den Wert 4.

Dann heißt der Ausdruck

$$S = sign(4 - 3) * sign(2 - 4)$$

Gemäß der vorgenannten Definition der Funktion sign folgt daraus, daß die Steigung S=-1, also negativ ist. Daraus kann auf eine fehlerfreie Funktion geschlossen werden.

Beim Beispiel aus Figur 7 folgt daraus, daß sich bei Zahlenwerten x(n)=2, x(n-1)=4; y(n)=3, y(n-1)=3,5 der Ausdruck

$$S = sign (2 - 4) * sign(3 - 3,5)$$

ergibt, was zu einer positiven Steigung von S=+1 führt. Daraus folgt eine Fehlermeldung.

Diese Aussage ist für beide möglichen Bewegungsrichtungen des Meßsystemes ebenso richtig wie für eine beliebige Reihenfolge der ausgewählten Meßwertpunkte.

**Patentansprüche**

1.  Verfahren zur Überwachung von analogen periodischen Meßsignalen bei inkrementalen Wegmeßsystemen, bei dem in an sich bekannter Weise von einem resultierenden Signalvektor ein Kreis beschrieben wird, wenn die momentanen Werte der Meßsignale in einem Koordinatensystem eingetragen werden, wobei der vom resultierenden Signalvektor (10) beschriebene Kreis (11) auf einen Quadranten des Koordinatensystems (x, y) abgebildet wird, daß anhand der zeitlichen Änderung des Signalvektors (10) das Vorzeichen (S) der Steigung einer zwei Meßwertpunkte (n-1;n) verbindenden Geraden (13, 13') ermittelt wird, wobei zur Ermittlung der zeitlichen Änderung des Signalvektors (109 jeweils die Koordinaten x(n-1), y(n-1); x(n), y(n) herangezogen werden, und daß die Ermittlung des Vorzeichens (S) der Steigung der diese Meßwertpunkte (n-1;n) verbindenden Geraden 13, 13′) durch Differenzbildung nach dem Term S = sign(x(n)-x(n-1 * sign(y(n)-y(n-1)) erfolgt und bei dem per Definition aus dem Vorzeichen (S) der Steigung der Geraden (13, 13′) eine Aussage über die Korrektheit oder die Fehlerhaftigkeit der Messung gewonnen werden kann.

2. Verfahren nach Anspruch 1, dadurch gekennzeichnet, daß bei negativem Vorzeichen (S) der Steigung der Geraden (13, 13′) die Messung korrekt ist, und daß sie fehlerhaft ist, wenn die Steigung (S) positiv ist.

3. Verfahren nach Anspruch 1, dadurch gekennzeichnet, daß das Verfahren in Verbindung mit einer digitalen Unterteilungsschaltung zur Interpolation der Meßsignale (U1, U2) durchgeführt wird.

4. Verfahren nach Anspruch 1, dadurch gekennzeichnet, daß das Verfahren in Verbindung mit einer analogen Unterteilungsschaltung zur Interpolation der Meßsignale (U1, U2) durchgeführt wird.

5. Verfahren nach Anspruch 1, dadurch gekennzeichnet, daß es mit Hilfe von digitalen Schaltkreisen oder mit analog arbeitenden Schaltkreisen durchgeführt wird.

## Claims

1. Method of monitoring analog periodic measurement signals in incremental distance measurements, in which in a known way a circle is described by a resultant signal vector, when the momentary values of the measurement signals are entered in a co-ordinate system, the circle (11) described by the resultant signal vector (10) being imaged on a quadrant of the co-ordinate system (x,y) , in that, by reference to the chronological change in the signal vector (10), the preceding sign (S) of the gradient of a straight line (13, 13′) connecting two measurement value points (n-1; n) is determined, the respective co-ordinate x( n-1), y(n-1);x(n), y(n-1) being used to determine the chronological change in the signal vector (10), and that determination of the preceding sign (S) of the gradient of the straight line (13, 13′) connecting these two measurement value point n-1; (n) is effected by differentiation according to the term S = sign (x(n)-x(n-1) * sign (y(n)-y(n-1)), and in which by definition, a statement may be obtained on the correctness or erroneous nature of the measurement from the preceding sign (S) of the gradient of the straight line (13, 13′).

2. Method according to Claim 1, characterised in that, when the preceding sign (S) of the gradient of the straight line (13, 13′) is negative, the measurement is correct, and in that it is erroneous when the gradient (S) is positive.

3. Method according to Claim 1, characterised in that the method is carried out in conjunction with a digital graduation circuit for interpolation of the measurement signals (U1, U2).

4. Method according to Claim 1, characterised in that the method is carried out in conjunction with an analog graduation circuit for interpolation of the measurement signals (U1, U2).

5. Method according to Claim 1, characterised in that it is carried out with the aid of digital switching circuits or with analog-operating switching circuits.

## Revendications

1. Procédé de contrôle de signaux de mesure périodiques analogiques dans des systèmes de mesure de déplacements, dans lequel, de manière connue en soi, un cercle est décrit par un vecteur résultant de signal lorsqu'on porte dans un système de coordonnées les valeurs instantanées des signaux de mesure, le cercle (11) décrit par le vecteur résultant (10) de signal étant reproduit dans un quadrant du système de coordonnées (x, y), on détermine à l'aide de la variation dans le temps du vecteur de signal (10) le signe (S) de la pente d'une droite (13, 13′) passant par deux points de mesure (n-1; n), les coordonnées x(n-1), y(n-1); x(n), y(n) étant utilisées pour déterminer la variation dans le temps du vecteur de signal (109), on détermine le signe (S) de la pente des droites (13, 13′) passant par lesdits points de mesure (n-1;n) en formant la différence conformément à S = sign(x(n) - x(n-1)) $*$ sign(y(n) - y(n-1)), et dans lequel, par définition, on peut déduire du signe (S) de la pente de la droite (13, 13′) une information sur l'exactitude ou le caractère erroné de la mesure.

2. Procédé selon la revendication 1, caractérisé par le fait que la mesure est exacte lorsque le signe (S) de la pente des droites (13, 13′) est négatif et qu'elle erronée lorsque le signe (S) de ladite pente est positif.

3. Procédé selon la revendication 1, caractérisé par le fait que le procédé est mis en oeuvre en liaison avec un circuit numérique de subdivision pour l'interpolation des signaux de mesure (U1, U2).

4. Procédé selon la revendication 1, caractérisé par le fait que le procédé est mis en oeuvre en liaison avec un circuit analogique de subdivision pour l'interpolation des signaux de mesure (U1, U2).

5. Procédé selon la revendication 1, caractérisé par le fait qu'il est mis en oeuvre à l'aide de circuits de commutation numériques ou de circuits de commutation analogiques.

FIG. 1

FIG. 2

T    T/4

U1

X

X

U2

FIG. 3

A/D

EXE

Z

FIG. 4

X

X

FIG. 5

FIG. 6

FIG. 7